(19) Europäisches Patentamt
European Patent Office
Office européen des brevets

(11) **EP 1 488 511 B1**

(12) **EUROPEAN PATENT SPECIFICATION**

(45) Date of publication and mention
of the grant of the patent:
**22.12.2010 Bulletin 2010/51**

(21) Application number: **03744575.6**

(22) Date of filing: **14.03.2003**

(51) Int Cl.:
**H03F 1/32** (2006.01)

(86) International application number:
**PCT/SE2003/000425**

(87) International publication number:
**WO 2003/079545 (25.09.2003 Gazette 2003/39)**

(54) **AN IMPLEMENTATION METHOD FOR PRE-DISTORTION OF NON-LINEAR DEVICES**

IMPLEMENTIERUNGSVERFAHREN ZUR VORVERZERRUNG NICHTLINEARER BAUELEMENTE

PROCEDE DE MISE EN OEUVRE D'UNE PRE-DISTORSION DE DISPOSITIFS NON LINEAIRES

(84) Designated Contracting States:
**AT BE BG CH CY CZ DE DK EE ES FI FR GB GR
HU IE IT LI LU MC NL PT RO SE SI SK TR**

(30) Priority: **19.03.2002 SE 0200861**

(43) Date of publication of application:
**22.12.2004 Bulletin 2004/52**

(73) Proprietor: **Telefonaktiebolaget LM Ericsson
(publ)
164 83 Stockholm (SE)**

(72) Inventors:
• **NYGREN, Thorsten
S-187 36 Täby (SE)**
• **REXBERG, Leonard
S-165 74 Hässelby (SE)**

(74) Representative: **Kühn, Friedrich Heinrich et al
Ericsson AB
Patent Unit LTE
Torshamnsgatan 23
164 80 Stockholm (SE)**

(56) References cited:
• **MURALI TUMMLA ET AL.: 'Volterra series based
modeling and compensation of nonlinearties in
high power amplifiers' pages 2417 - 2420,
XP010226429**
• **SEKCHIN CHANG ET AL.: 'A compensation
scheme for nonlinear distortion in OFDM
systems' pages 736 - 740, XP001017184**
• **ANDING ZHU ET AL.: 'An adaptive volterra
predistorter for the linearization of RF high power
amplifiers' pages 461 - 464, XP001099528**

**Description**

TECHNICAL FIELD

The present invention relates to optimisation of pre-distortion as a means to linearize inherently non-linear devices.

BACKGROUND

Linearization of inherently non-linear devices is necessary if distortion of signals through the device is to be minimised. Specifically when it concerns amplifiers in wireless communications it is in most cases necessary to limit spurious signal generation at out-of-band frequencies and also in some cases at in-band frequencies. One of the most frequently used techniques involves subtracting the unwanted signal portion from the output of the device by a feed-forward technique. The non-distorted input signal is then subtracted from an attenuated copy of the distorted output signal to give an estimate of the added spurious signal components, which may be again subtracted from the output signal by proper amplification and phase alignment. This technique is as suggested by the description above referred to as "Feed Forward" techniques, FF.

Another method to compensate for unwanted signal components is to find a mathematical operator which, if applied to the input signal, gives enough anti-distortion to compensate for the non-linearities of the device itself. This operator will if placed in a cascade configuration cancel out the unwanted signal components at the non-linear device output. This technique is referred to as "Pre-Distortion" techniques, PD.

A specific application of non-linear pre-distortion is to combat non-linear effects in power amplifiers for cellular communications. As capacity will drive the evolution of existing and forthcoming standards to deliver a higher number of user channels per bandwidth, amplifiers will have to be used in a broadband fashion. That is, if fed through a non-linear amplifier, these channels or frequencies would interfere with each other and also produce unwanted spurious signals in other frequency bands which are used by other network providers or mobile users.

A realisation that uses the previously mentioned FF technique is the Multi Carrier Power Amplifier (MCPA). This device incorporates delicate tuning circuits for amplitude and phase matching so that at the end only the distortion part is subtracted from the output signal. A way to strengthen the linearization would be to cascade a pre-distorter or alternatively linearize the internal amplifier itself. In the process of doing so, it is expected that the overall efficiency will also become higher. Another way is to actually take away the FF circuitry and solely rely on a good pre-distorter and good internal amplifier. It is believed that this would beneficially decrease manufacturing cost and also provide a simpler overall design.

STATE-OF-THE-ART

State-of-the-art of pre-distortion is to compare samples of the signals measured at the input and output ports of a non-linear device, and then compensate by amplifying or attenuating the specific amplitude level. In this way a non-linear amplitude characteristic function is obtained by which non-linear effects may be compensated for. Phase adjustment can be made in a similar way.

Another method, described in [2]-[4], may incorporate a more detailed algorithm whereby the characteristics of the non-linear device is tracked by time-dynamical methods such as expansion of the Volterra series, in order to find a closed expression for the device. The next step would then be to find an inverse to this function by the same expansion and apply it as a pre-distorter.

SUMMARY

The disclosure of the present invention proposes a new specific method to calculate and optimise the pre-distorter avoiding the need of time-alignment between input and output of the MCPA. That is, the analogue output spectrum is used directly to compute an optimum pre-distorter, either in digital or analogue format.

The method of computing the parameters of the pre-distorter is usually to compare the input signal to the output signal, and then in some manner adjust the parameters in such a way as to minimise distortion at the output of the non-linear device. Usually this means a careful time or phase alignment of input-to-output signals, which makes it a somewhat difficult task to actually implement.

Moreover, it usually involves some sort of modelling of the pre-distorter in conjunction with the power amplifier itself. In this way, the optimisation procedure is somewhat twofold in that it needs modelling of two items within the iteration procedure. It would be expected that the iteration process gets rather involved and also takes time to perform.

In the output only method, it poses some problems as how to express the target signal and the actual mathematical equations to solve.

The solution proposed to the above problem is using the output spectrum directly to optimise intermodulation performance, rather than trying to match the input spectrum to the output spectrum. That is, the output spectrum (except for a possible gain constant) can be used as input to the optimisation procedure directly. Since the intermodulation products usually are of much lower amplitude than the carriers themselves, it can be taken as the input spectrum without major loss of confinement. The present disclosure outlines in detail the mathematical procedure to actually calculate a proper pre-distorter using only the output signal.

As a second improvement, the spurious frequency components are directly suppressed to zero, without the need for approximating the target input signal by even a filtered version of the output signal. In this case, only information about a gain constant and at which frequency components or frequency band the pre-distortion should achieve zero magnitude.

A method of optimising pre-distortion means is set forth by the claims.

SHORT DESCRIPTION OF THE DRAWINGS

The invention, together with further objects and advantages thereof, may best be understood by making reference to the following description taken together with the accompanying drawings, in which:

FIG. 1     illustrates an amplifier with an amplitude gain G, and being described by a non-linear operator Ho(x), the gain G being defined by the relation of average power ratio of x and y;

FIG. 2     illustrates a pre-distorter in a cascade configuration with a non- linear device, whereby the pre-distorter acts as an inverter to operator Ho(x) except for the transfer gain (G) through the device;

FIG. 3     illustrates a first inversion method, wherein the output signal is inverted back to the input signal by using a filtered version of the output signal as an approximation of the original input signal, whereby the inverter also tries to keep the in-band frequency components of the spurious spectrum intact;

FIG. 4     illustrates optimising of a pre-distorter by using only output signal, whereby the pre-distorter is optimised to produce no spurious frequency components in frequency regions A + C only, and the result is that no spurious frequency components at in-band frequency spectrum are forced to be maintained thereby producing an even "cleaner" spectrum than in Figure 3; and

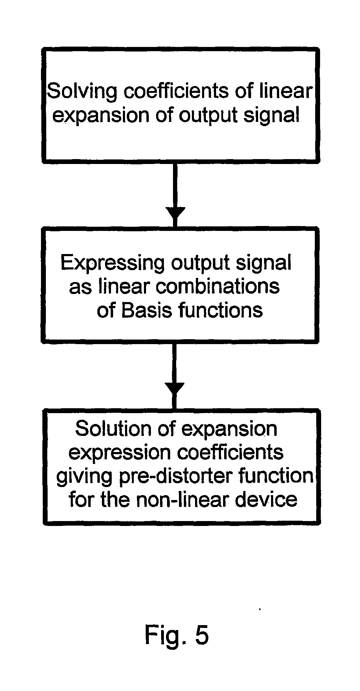

FIG. 5     illustrates the main steps of the method according to the present invention.

TECHNICAL DESCRIPTION

Least mean squares approach

It is tempting to insert a general pre-distorter at the input of a non-linear device, and then try to optimise the parameters in such a way that a given cost-function at the output of that device is minimised. However, it will prove that such an attempt will cause the optimisation algorithm to find itself in local minima. In general, it is difficult to find a good solution to the optimisation problem in this way. Another way is to invert the output signal such as to equal the input signal. This inverter can then directly be inserted acting as the pre-distorter. As stated above and will be described further below, it is also possible to use only the output signal itself for the calculations with only some minor knowledge of the input signal.

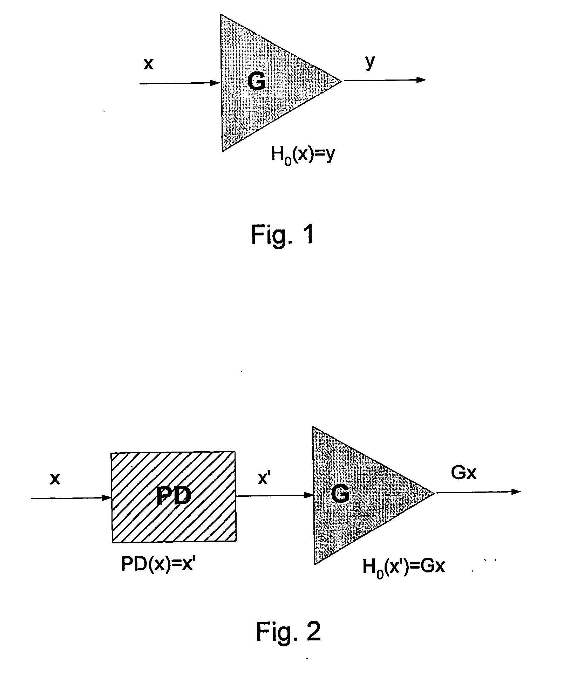

In view of Figure 1 the following equation may be written down, together with the inverse solution to the equation:

$$H_0[x] = y \qquad \Rightarrow \qquad x = H_0^{-1}[y] \qquad (1)$$

Likewise, we may write for the signal equality in Figure 2 that:

$$H_0[PD(x)]=G \cdot x \qquad \text{or} \qquad PD(x)=H_0^{-1}[G \cdot x] \qquad (2)$$

So, given the inverse operator of the non-linear device immediately gives the pre-distorter function in a straightforward mathematical way. That is, given that the inverse operator actually exists this strictly holds. This suggests that the key issue is to solve Equation (1) above, and then just apply this non-linear operator in cascade with the non-linear device by compensating for the amplitude gain (G).

A somewhat simpler way to solve Equation (1) above, than first estimate Ho and then try to invert the operator, is to immediately solve for the inverse operator without bothering to solve for the forward case first. That is, part of this disclosure is to solve for the following equation:

$$H_0^{-1}[y]=x \qquad \text{or} \qquad F[y]=x \qquad (3)$$

The next step in the proposed method is to expand this operator in, for example, a dynamic Volterra series. Note that also possibly other expansions may be successful. It can be shown [1] that if a system can be described in terms of a Volterra series and if the inverse operator exists, then there must also exist a complete Volterra series that equates to the inverse operator. Already here we recognise that this Volterra series can then be directly applied to the input signal, which will give the necessary pre-distortion to give a linear input/ output relation.

Note that we are still discussing input-to-output relations at this stage. In a few steps of the development of this disclosure we will drop this distinction as to emerge at a desired method for output signal optimisation only.

Proceeding with the development of the pre-distorter we may conclude that for example a Volterra series expansion of the following form satisfies Equation (3) above:

$$\sum_n a_n y_{k-n} + \sum_n \sum_m a_{n,m} y_{k-n} y_{k-m} + \sum_n \sum_m \sum_p a_{n,m,p} y_{k-n} y_{k-m} y_{k-p} \ldots\ldots = x_k \qquad (4)$$

for each time sample 'k'.

It should be mentioned that the Volterra series might not be the only possible description of the pre-distorter. To a designer skilled in the art it is obvious that also other functions or linear combinations of functions are possible. Specifically, the solution to the above Equation (4) may be obtained in a number of ways. In this disclosure we will be using the Least Mean Squares solution (LMS), but also other methods are possible. Further, using notations for Basis functions instead of the individual Volterra terms, we get the following equation in matrix form:

$$\begin{bmatrix} B_{k,1} & B_{k,2} & B_{k,3} & B_{k,4} & \ldots\ldots \end{bmatrix} \cdot \begin{bmatrix} b_1 \\ b_2 \\ b_3 \\ \vdots \end{bmatrix} = x_k \qquad (5)$$

For instance in the above equation, $B = y_{k-n} y_{k-m} y_{k-p}$ and the $b$'s correspond $a$'s in Equation (4) above. It is also clear from Equation (5) that B can be any basis functions, which when linearly combined approximates the characteristics of the pre-distorter. If, for each instance of time sample k, new values for the Basis functions $B_k$ and for the $x_k$ values is computed and measured, respectively, we get:

$$\begin{bmatrix} B_{1,1} & B_{1,2} & B_{1,3} \cdots \\ B_{2,1} & B_{2,2} & B_{2,3} \cdots \\ B_{3,1} & B_{3,2} & B_{3,3} \cdots \\ B_{4,1} & B_{4,2} & B_{4,3} \cdots \\ B_{5,1} & B_{5,2} & B_{5,3} \cdots \\ \vdots & \vdots & \vdots \end{bmatrix} \cdot \begin{bmatrix} b_1 \\ b_2 \\ b_3 \\ \vdots \end{bmatrix} = \begin{bmatrix} x_1 \\ x_2 \\ x_3 \\ \vdots \end{bmatrix} \qquad (6)$$

The above matrix equation is over-determined, which means that the solution cannot be obtained from just inverting the matrix, since only quadratic matrices may be inverted. A solution to this is to apply the LMS solution, which is well understood and has been used in numerous other applications. The steps are as outlined below:

$$B \cdot b = x \qquad (7)$$

Multiply by $B^H$ (complex transpose) from the left:

$$B^H \cdot B \cdot b = B^H \cdot x \qquad (8)$$

which gives the following solution:

$$b = \left[ B^H \cdot B \right]^{-1} \cdot B^H \cdot x \qquad (9)$$

Given the coefficients $b$ of Equation (9) and inserted into Equation (4) constitutes the full pre-distorter for the non-linear device. This is a solution found by only linear methods to an inherently non-linear problem. Below is given specific methods of how to use only the output signal which can be used to further enhance performance in terms of suppressing spurious frequencies while having the in-band signal unchanged. It should further be noted that Equation (9) incorporates both the input and output signals.

Frequency version of LMS approach

A frequency version of this method (as described above) may also be employed. Having in mind that each column of Equation (6) constitutes a time sweep for a particular Basis function (Volterra term), we may perform a Fourier transform on each of these columns separately, and also perform a Fourier transform of the right-hand side column. Now we have a frequency version of Equation (6), which may be solved by the same LMS procedure as outlined above. The result should be congruent with the solution shown in Equation (9), which expresses this equation in time domain.
The procedure of the Fourier transform method is outlined as follows. Assume the same equation as in Equation (6) above. In a more clear way to write this equation, we may write it as a function of time as:

$$\begin{bmatrix} B_{1,1}(t_1) & B_{1,2}(t_1) & B_{1,3}(t_1)\cdots \\ B_{2,1}(t_2) & B_{2,2}(t_2) & B_{2,3}(t_2)\cdots \\ B_{3,1}(t_3) & B_{3,2}(t_3) & B_{3,3}(t_3)\cdots \\ B_{4,1}(t_4) & B_{4,2}(t_{24}) & B_{4,3}(t_{24})\cdots \\ B_{5,1}(t_5) & B_{5,2}(t_5) & B_{5,3}(t_5)\cdots \\ \vdots & \vdots & \vdots \end{bmatrix} \cdot \begin{bmatrix} b_1 \\ b_2 \\ b_3 \\ \vdots \end{bmatrix} = \begin{bmatrix} x_1(t_1) \\ x_2(t_2) \\ x_3(t_3) \\ \vdots \end{bmatrix} \quad \begin{matrix}\downarrow\\ \textit{time} \\ \downarrow\end{matrix} \tag{10}$$

Now, taking the Fourier transform of each column in Equation (10) gives the following equation:

$$\begin{matrix}\textbf{FFT}\\ \downarrow\end{matrix}$$

$$\begin{bmatrix} BF_{1,1}(\omega_1) & BF_{1,2}(\omega_1) & BF_{1,3}(\omega_1)\cdots \\ BF_{2,1}(\omega_2) & BF_{2,2}(\omega_2) & BF_{2,3}(\omega_2)\cdots \\ BF_{3,1}(\omega_3) & BF_{3,2}(\omega_3) & BF_{3,3}(\omega_3)\cdots \\ BF_{4,1}(\omega_4) & BF_{4,2}(\omega_4) & BF_{4,3}(\omega_4)\cdots \\ BF_{5,1}(\omega_5) & BF_{5,2}(\omega_5) & BF_{5,3}(\omega_5)\cdots \\ \vdots & \vdots & \vdots \end{bmatrix} \cdot \begin{bmatrix} b_1 \\ b_2 \\ b_3 \\ \vdots \end{bmatrix} = \begin{bmatrix} xF_1(\omega_1) \\ xF_2(\omega_2) \\ xF_3(\omega_3) \\ \vdots \end{bmatrix} \quad \begin{matrix}\downarrow\\ \text{frequency} \\ \downarrow\end{matrix} \tag{11}$$

Or in compact form:

$$BF \cdot b = xF \tag{12}$$

Equation (11) is a frequency version of the original Equation (6). In a likewise manner to the solution shown in Equation (9), we may directly write down the LMS solution to the frequency version as outlined in Equation (11) above:

$$b = \left[BF^H \cdot BF\right]^{-1} \cdot BF^H \cdot xF \tag{13}$$

Frequency weighting

A further improvement to the solution would be to multiply certain rows of Equation (10) corresponding to a certain frequency as to obtain a weighting of these certain frequency responses. Spurious frequency components in certain frequency bands may be given higher importance than other frequency bands. This procedure will improve the solution to give a better pre-distortion performance.

$$\begin{bmatrix} BF_{1,1}(\omega_1) & BF_{1,2}(\omega_1) & BF_{1,3}(\omega_1)\cdots \\ C_1 \cdot BF_{2,1}(\omega_2) & C_1 \cdot BF_{2,2}(\omega_2) & C_1 \cdot BF_{2,3}(\omega_2)\cdots \\ C_2 \cdot BF_{3,1}(\omega_3) & C_2 \cdot BF_{3,2}(\omega_3) & C_2 \cdot BF_{3,3}(\omega_3)\cdots \\ BF_{4,1}(\omega_4) & BF_{4,2}(\omega_4) & BF_{4,3}(\omega_4)\cdots \\ BF_{5,1}(\omega_5) & BF_{5,2}(\omega_5) & BF_{5,3}(\omega_5)\cdots \\ \vdots & \vdots & \vdots \end{bmatrix} \cdot \begin{bmatrix} b_1 \\ b_2 \\ b_3 \\ \vdots \end{bmatrix} = \begin{bmatrix} xF_1(\omega_1) \\ C_1 \cdot xF_2(\omega_2) \\ C_2 \cdot xF_3(\omega_3) \\ \vdots \end{bmatrix} \qquad (14)$$

This equation is then solved exactly as described above in the sense of Least Mean Squares.

Output only LMS

As mentioned earlier, it is also possible to calculate the pre-distorter by extracting only the output signal. Now, let us assume that the non-linearity is limited so that only minor non-linearities occur in the output signal. Then we might instead replace the signal "x" in Equations (4)-(9) by a filtered version of the amplifier signal "y". The filter may be coarse enough just to drop spurious emissions outside a given main frequency band. The difference to the original input signal is then the in-band distortion, which can often be accepted. Moreover, it turns out that minimising out-of-band distortion will also have effect at in-band frequencies. Following this outlined path, the approximate solution to Equation. (15) would be as outlined in Equation. (16).

$$b = \left[ B(y)^H \cdot B(y) \right]^{-1} \cdot B(y)^H \cdot x \qquad (15)$$

$$\tilde{b} = \left[ B(y)^H \cdot B(y) \right]^{-1} \cdot B(y)^H \cdot filt\{y\} \qquad (16)$$

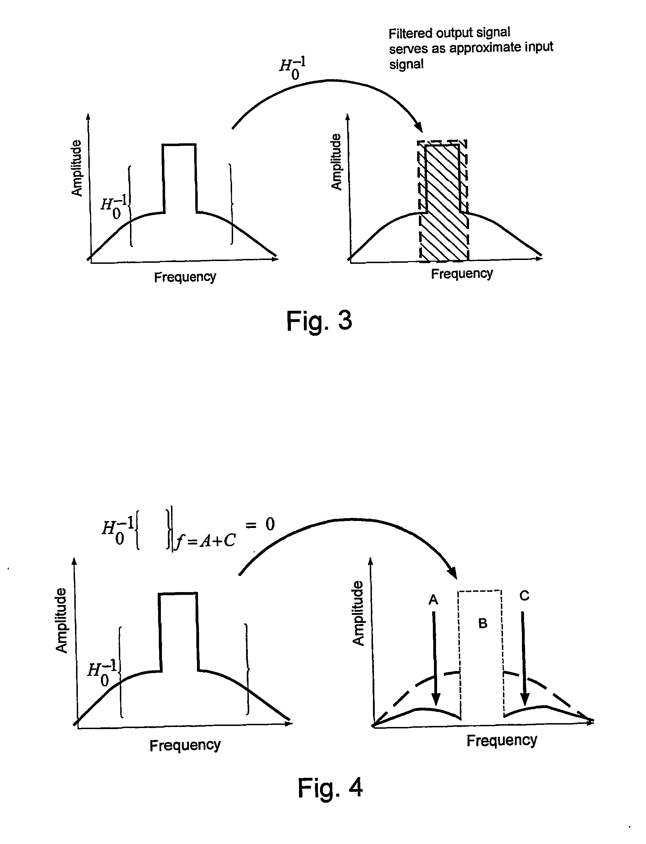

Where $filt\{y\} \approx x$ is a filtered version of the output signal $y$ (see Figure 3).
We may assume that, if the distortion is small enough, a filtered version of the output signal may approximate the input signal. The only knowledge that is required of the input signal is the average power relation to the output signal, and to what extent the output-signal replica should be filtered. The latter issue may be satisfied by for example only requiring that the intermodulation products (or spurious frequency response) should be zero below some pre-defined threshold level. Even though this filtered version of the output signal does indeed contain in-band distortion components; it is assumed that this level is low enough not to introduce large errors. Normally, devices used to amplify signals are from the beginning relatively linear, whereby the above statement of low enough distortion is automatically satisfied.
If the non-linear device is frequency dependent, the pre-distorter function can be improved by adding a pre-set frequency equalizer at the device input.

Direct suppression of spurious frequencies

It is also possible to just suppressing the spurious frequency components of the output spectrum by just considering those frequencies alone. That is, without directly equating any inversion equation, we may suppress the unwanted spectrum directly. Let us as an example use the Volterra series expansion of the inverter in plain polynomial form without memory effects, and just setting the spurious frequencies to zero:

$$a_0 \cdot FFT(y) + a_1 \cdot FFT(y^3) + a_2 \cdot FFT(y^5) \quad \cdots \quad = 0 \big|_{\text{spurious frequencies}} \qquad (17)$$

$$a_1 \cdot \text{FFT}\left(y^3\right) + a_2 \cdot \text{FFT}\left(y^5\right) \quad \cdots \quad = -a_0 \cdot \text{FFT}\left(y\right)\Big|_{\text{spurious frequencies}} \qquad (18)$$

In Equation (18), we only use those rows in the general matrix, which correspond to those particular frequencies where we would like the spectrum to become zero (See parts A and C in Figure 4). As seen, the right-hand-side of Equation (18) contains the apparently unknown coefficient $a_0$. However, as we know the amplification through the system we also know this coefficient. So clearly, we again have a linear system of equations that can be solved by the LMS algorithm. The obvious benefit of the latter method is that we no longer use a substitute for the in-band signal for the optimisation. This avoids the LMS method trying to actually keep the output signal in the wanted frequency region, but rather tries to restore the input signal even in this frequency band.

It is also noted that the wanted in-band spectrum is not used in the formulation. This suggests that we would actually have no control of the in-band vector error. However, as the unwanted frequency components in Regions A and C in Figure 4 are suppressed, then with a high confidence also the in-band spurious frequency components will also be suppressed.

Also in this case, if the non-linear device is frequency dependent, the pre-distorter function can be improved by adding a pre-set frequency equalizer at the device input.

MERITS OF INVENTION

Among the merits of this invention disclosure is the fact that a linear method can be applied to an inherently non-linear problem. The Least Mean Squares solution is applied in a classical way to directly extract the coefficients of a linear combination of Basis functions. As an example, the coefficients of a Volterra series can be readily applied and solved by this method.

The second merit of this disclosure is that frequency weighting of the cost-function may be obtained as to pronounce certain frequency regions in favour of other bands. It is noted that the mathematical formulation is still a linear one, and no iterative search algorithm is used to find the optimum solution to the problem.

The third merit of the invention is that output-only optimisation may be used effectively by reproducing the input signal characteristics from only the output signal and some minor knowledge such as wanted frequency band and power amplification.

The fourth merit is that the suggested improvement of just suppressing the unwanted frequency components gives the ability to pre-distort a non-linear device with the result of an output signal without vector errors. That is, the latter improvement searches to purely minimise the unwanted frequency components.

REFERENCES

[1] V. John Mathews, Giovanni L. Sicuranza, "Polynomial Signal Processing", SBN 0471-03414-2

[2] Murali Tummla et al.: "Volterra series based modelling and compensation of nonlinearities in high power amplifiers", pages 2417-2420, XPO10226429

[3] Sekchin Chang et al.: "A compensation scheme for nonlinear distortion in OFDM system". pages 736-740, XP001017184

[4] Anding Zhu et al.: "An adaptive Volterra predistorter for the linearization of RF high power amplifiers", pages 461-464, XP001099528

Claims

1. A method for optimization of pre-distortion of a non-linear device, comprising:

   solving coefficients of a linear expansion expression for an output signal of the non-linear device;
   expressing an inverter output signal as a linear combination of Basis functions which equates to an input signal of the non-linear device, whereby a solution for the coefficients of the linear expansion expression gives a pre-distorter function being an inverse operator to the non-linear device;
using the output signal of said non-linear device only as approximation of a target input signal of the non-linear device;
filtering out spurious frequency components, whereby parameters for filtering are frequency components of amplitudes below a pre-set threshold value; and
adjusting a target input signal level by measuring linear gain of the non-linear device.

2. The method according to claim 1, comprising:

suppressing a spurious frequency spectrum in the frequency domain, whereby a target input signal of the non-linear device is considered to have frequency components of zero magnitude outside a wanted spectrum.

3. The method according to claim 2, comprising:

expanding the output signal by a series representation,
applying a Fourier transformation to each column of a matrix equation representing the output signal as a function of time to convert into frequency domain,
assigning a coefficient to a linear part of the expansion to satisfy a gain requirement, and
formulating a least mean squares approach or equivalent for remaining coefficients.

4. The method according to claim 3, comprising: using for the series representation a dynamic Volterra series expansion.

5. A method to optimize an inverse operator for a distortion function associated with a non-linear amplifier, comprising: minimizing an output signal spectrum of the inverse operator in accordance with any of the preceding claims.

6. The method of claim 5, comprising using different weighting factors in different frequency bands.


**Patentansprüche**

1. Verfahren zur Optimierung der Vorverzerrung einer nichtlinearen Vorrichtung, umfassend:

Lösen von Koeffizienten eines linearen Entwicklungsausdrucks für ein Ausgangssignal der nichtlinearen Vorrichtung;
Ausdrücken eines Inverter-Ausgangssignals als eine lineare Kombination von Basis-Funktionen, die einem Eingangssignal der nichtlinearen Vorrichtung entspricht, wobei eine Lösung für die Koeffizienten des linearen Entwicklungsausdrucks eine Vorverzerrerfunktion ergibt, die ein inverser Operator für die nichtlineare Vorrichtung ist;
Verwenden des Ausgangssignals der nichtlinearen Vorrichtung nur als Näherung eines Ziel-Eingangssignals der nichtlinearen Vorrichtung;
Herausfiltern von Störfrequenzkomponenten, wobei Parameter zum Filtern Frequenzkomponenten von Amplituden unter einem im Voraus eingestellten Schwellenwert sind; und
Anpassen eines Ziel-Eingangssignalpegels durch Messen der linearen Verstärkung der nichtlinearen Vorrichtung.

2. Verfahren nach Anspruch 1, umfassend:

Unterdrücken eines Störfrequenzspektrums in der Frequenzdomäne, wobei ein Ziel-Eingangssignal der nichtlinearen Vorrichtung als Frequenzkomponenten der Größenordnung null außerhalb eines erwünschten Spektrums habend betrachtet wird.

3. Verfahren nach Anspruch 2, umfassend:

Erweitern des Ausgangssignals durch eine Reihendarstellung,
Anwenden einer Fourier-Transformation auf jede Spalte einer Matrixgleichung, die das Ausgangssignal als eine Funktion der Zeit repräsentiert, zur Umwandlung in die Frequenzdomäne,
Zuweisen eines Koeffizienten zu einem linearen Teil der Entwicklung, um eine Verstärkungsanforderung zu erfüllen, und

Formulieren einer Näherungsweise der kleinsten mittleren Quadrate oder gleichwertig für die übrigen Koeffizienten.

**4.** Verfahren nach Anspruch 3, umfassend: Verwenden einer dynamischen Volterra-Reihenentwicklung für die Reihendarstellung.

**5.** Verfahren zum Optimieren eines inversen Operators für eine Verzerrungsfunktion, die mit einem nichtlinearen Verstärker assoziiert ist, umfassend: Minimieren eines Ausgangssignalspektrums des inversen Operators in Übereinstimmung mit einem der vorstehenden Ansprüche.

**6.** Verfahren nach Anspruch 5, umfassend, verschiedene Gewichtungsfaktoren in verschiedenen Frequenzbändern zu verwenden.

**Revendications**

**1.** Procédé d'optimisation de pré-distorsion d'un dispositif non linéaire, consistant à :

résoudre les coefficients d'une expression de développement linéaire pour un signal de sortie du dispositif non linéaire ;
exprimer un signal de sortie d'inverseur en tant que combinaison linéaire de fonction de base qui est égale à un signal d'entrée du dispositif non linéaire, moyennant quoi une solution pour les coefficients de l'expression de développement linéaire donne une fonction de pré-distorsion qui est un opérateur inverse au dispositif non linéaire ;
utiliser le signal de sortie dudit dispositif non linéaire uniquement en tant qu'approximation d'un signal d'entrée cible du dispositif non linéaire ;
filtrer les composantes de fréquence parasites, moyennant quoi les paramètres de filtrage sont des composantes de fréquence d'amplitudes inférieures à une valeur de seuil prédéterminée ; et
ajuster un niveau de signal d'entrée cible en mesurant le gain linéaire du dispositif non linéaire.

**2.** Procédé selon la revendication 1, consistant à :

supprimer un spectre de fréquence parasite dans le domaine fréquentiel, moyennant quoi un signal d'entrée cible du dispositif non linéaire est considéré comme ayant des composantes de fréquence d'amplitude nulle en-dehors d'un spectre souhaité.

**3.** Procédé selon la revendication 2, consistant à :

développer le signal de sortie en une représentation série ;
appliquer une transformation de Fourier à chaque colonne d'une équation matricielle représentant le signal de sortie en fonction du temps pour une conversion dans le domaine fréquentiel,
attribuer un coefficient à une partie linéaire du développement pour satisfaire à une spécification de gain, et
formuler une approche des moindres carrés ou un équivalent pour les coefficients restants.

**4.** Procédé selon la revendication 3, consistant à utiliser, pour la représentation série, un développement en série de Volterra dynamique.

**5.** Procédé d'optimisation d'un opérateur inverse pour une fonction de distorsion associée à un amplificateur non linéaire, consistant à réduire à un minimum un spectre de signal de sortie de l'opérateur inverse selon l'une quelconque des revendications précédentes.

**6.** Procédé selon la revendication 5, consistant à utiliser différents coefficients de pondération dans différentes bandes de fréquence.

x → **G** → y

$H_0(x)=y$

## Fig. 1

x → **PD** → x' → **G** → Gx

$PD(x)=x'$

$H_0(x')=Gx$

## Fig. 2

$H_0^{-1}$

Filtered output signal
serves as approximate input
signal

Amplitude

$H_0^{-1}$

Frequency

Amplitude

Frequency

Fig. 3

$H_0^{-1} \Big\{ \quad \Big| \Big|_{f=A+C} = 0$

Amplitude

$H_0^{-1}$

Frequency

Amplitude

A          C

B

Frequency

Fig. 4

Solving coefficients of linear
expansion of output signal

Expressing output signal
as linear combinations
of Basis functions

Solution of expansion
expression coefficients
giving pre-distorter function
for the non-linear device

Fig. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **V. John Mathews ; Giovanni L. Sicuranza.** *Polynomial Signal Processing,* ISBN 0471-03414-2
- **Murali Tummla et al.** *Volterra series based modelling and compensation of nonlinearities in high power amplifiers,* 2417-2420
- **Sekchin Chang et al.** *A compensation scheme for nonlinear distortion in OFDM system,* 736-740
- **Anding Zhu et al.** *An adaptive Volterra predistorter for the linearization of RF high power amplifiers,* 461-464